Europäisches Patentamt

European Patent Office

Office européen des brevets

(11) Publication number: **0 301 689 B1**

# EUROPEAN PATENT SPECIFICATION

(45) Date of publication of patent specification: **29.09.93**    (51) Int. Cl.⁵: **H01L 39/12**, H01L 39/24

(21) Application number: **88304684.9**

(22) Date of filing: **24.05.88**

(54) **Method of stabilizing high Tc superconducting material and the material so stabilized.**

(30) Priority: **27.07.87 US 77840**
**10.12.87 US 131149**

(43) Date of publication of application:
**01.02.89 Bulletin  89/05**

(45) Publication of the grant of the patent:
**29.09.93 Bulletin  93/39**

(84) Designated Contracting States:
**AT BE CH DE ES FR GB GR IT LI LU NL SE**

(56) References cited:
**EP-A- 0 300 567**

**PATENT ABSTRACTS OF JAPAN, vol. 9, no. 169 (E-328)[1892], 1985; & JP-A-60 043 883 (NIPPON DENSHIN DENWA KOSHA) 08-03-1985**

**PHYSICAL REVIEW LETTERS, vol. 58, no. 24, 15th June 1987, pages 2579-2581, The American Physical Society, New York, US; S.R. OVSHINSKY et al.: "Superconductivity at 155 K"**

(73) Proprietor: **Ovonic Synthetic Materials Company, Inc.**
**1100 West Maple Road**
**Troy Michigan 48084(US)**

(72) Inventor: **Ovshinsky, Stanford R.**
**2700 Squirrel Road**
**Bloomfield Hills Michigan 48013(US)**
Inventor: **Fournier, Eugene**
**28760 Cambridge Garden City**
**Michigan 48135(US)**
Inventor: **Young, Rosa**
**1490 Brentwood**
**Troy Michigan 48098(US)**

(74) Representative: **Jackson, Peter Arthur et al**
**GILL JENNINGS & EVERY, Broadgate House,**
**7 Eldon Street**
**London EC2M 7LH (GB)**

ADVANCED CERAMIC MATERIALS- CERAMIC SUPERCONDUCTORS, vol. 2, no. 3B, July 1987, pages 506-511, ACerS, Westerville, OH, US; B. BENDER et al.: "Processing and properties of the high Tc superconducting oxide ceramic YBa2Cu3O7"

MODERN PHYSICS LETTERS B, vol. 2, no. 10, 1988, pages 1183-1188, World Scientific Publishing Co.; A. TRESSAUD et al.: "Passivation process of high Tc superconductors YBa2Cu3O7-delta by fluorine gas treatment"

**Description**

The instant invention relates generally to high transition temperature superconductors, as exemplified by, but not limited to, the newly discovered high transition temperature "1-2-3" or perovskite, ceramic defect oxide class of superconducting materials having the general composition $M^{IIA}M^{IIIA}M^{IB}O$; where $M^{IIA}$ is a Group IIA metal, $M^{IIIA}$ is a Group IIIA metal, and $M^{IB}$ is a Group IB metal; and more particularly to a method of stabilizing the critical temperature of those superconducting materials.

In late 1986, the superconducting properties of certain defect oxide ceramic type materials, which materials are variations of a well-known class of inorganic structures called perovskites, were observed by Bednorz and Mueller. The Bednorz and Mueller work was based upon materials developed by Michel and Raveau. The materials which Bednorz and Mueller observed contained lanthanum, barium, copper, and oxygen, and were reported to be superconducting at a temperature of about 30 degrees Kelvin.

Subsequently, researchers were able to increase the critical temperature, $T_c$, by the substitution of yttrium for lanthanum. Upon analysis, the superconducting composition was found to be a perovskite defect oxide of the $Y_1Ba_2Cu_3O_x$ type, possibly an orthorhombically distorted perovskite. Further work with this high $T_c$ phase effectively raised the critical temperature thereof to a few degrees above 90 degrees Kelvin (a temperature above the atmospheric boiling point of liquid nitrogen).

Other workers in the field have attempted the total and/or partial replacement of the yttrium and/or lanthanum with other Group IIIA metals (including Rare Earth elements), especially scandium, europium, lutetium, neodymium, praseodymium, and gadolinium. The same and still other workers in the field have also attempted the total and/or partial replacement of barium with other group IIA metals, such as strontium and calcium.

The superconducting perovskite type materials are ceramic defect oxides. That is, the superconducting phases of the perovskite type materials are solids in which different kinds of atoms occupy structurally equivalent sites, and where, in order to preserve electrical charge neutrality, some sites are unoccupied, i.e., vacant. Since these vacancies can be filled with mobile oxygen atoms, local disorder is prevalent. It is also clear that these vacancies form lattice defects, which defects have, generally, profound affects on the electrical parameters of the material and, more particularly profound affects on the oxidation states of the $M_3^{IB}$ (copper) atoms.

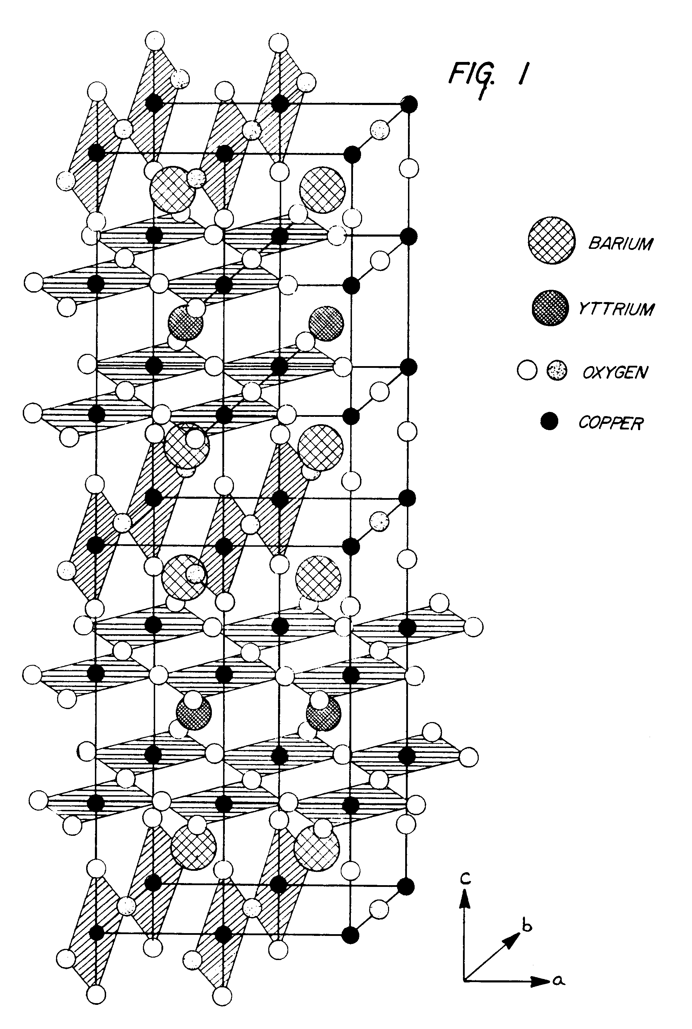

The structure shown in FIGURE 1 represents several repeating unit cells of the superconductor $YBa_2Cu_3O_7$ This structure has a recurring pattern of (1) a Cu-O plane of a first type with vacant O sites, (2) a Ba-O plane, (3) a Cu-O plane of a second type with fully occupied O sites, (4) a Y-O plane with O sites, (5), another Cu-O plane of the first type with fully occupied O sites, (6) another plane of the Ba-O type, and (7) a second Cu-O plane of the first type, with vacant O sites. It may thus be seen that the unit cell of the superconducting material so formed has seven planes spacedly disposed along the c axis thereof.

More particularly, the central plane of each of the multiple unit cells shown in FIGURE 1 is a Y-O plane with yttrium being surrounded at its four coplanar corners by four occupied oxygen sites. Immediately above and below this Y-O plane are equivalent Cu-O planes in which the copper atoms are at the four corners of the plane and occupied oxygen sites are along each edge of the planes. A pair of Ba-O planes lie atop and below these fully occupied Cu-O planes. The barium lies at the center of the planes with the oxygens disposed directly above and below the copper metal sites of the superjacent and subadjacent planes. The Ba-O planes are disposed between Cu-O planes with the Cu-O plane with oxygen vacancies disposed on side thereof relative to the Cu-O plane with fully occupied oxygen sites. As mentioned above, the vacancies (unoccupied sites) reported to reside in the Cu-O plane are the result of the requirement of electrical neutrality. The complexity of the unit cell has provided for numerous modes of modification of the constituent elements thereof, some of which modifications have resulted in higher transition temperatures.

For example, we have previously provided evidence of a multiphase superconducting material containing a sufficient volume fraction of superconducting phases to obtain zero resistance at a temperature as high as 155 to 168 Kelvin. This material was synthesized through the use of "modification" techniques. This material also gave magnetic indication of the presence of yet higher temperature superconducting phases. In addition, electrical conductivity measurements of the "modified" superconducting materials revealed a resistance value approximately four times lower than that of single-crystal copper before the zero-resistance state is reached. This indicates the presence of a phenomenologically significant volume fraction of other higher transition superconducting phases. Recent magnetic measurements of the modified superconducting material indicate a detectable volume fraction of superconducting phases at temperatures as high as about 370 Kelvin.

These results were obtained through the introduction of a "parametric modifier" into the unit cell of the superconducting material so as to improve the superconducting properties thereof. It was through the use of a parametric modifier that the instant inventors provided a new mechanism for affecting fundamental, critical temperature determining, parameters of said superconducting materials. It was also in this manner that the door was opened for further increases in critical temperatures of superconducting materials, even beyond the 155-168 degree Kelvin temperatures. More specifically, the addition of one parametric modifier, fluorine, to the superconducting material resulted in the identification of a superconducting phase of said defect oxide ceramic type material which has recently been shown to become superconducting at about 32 ° C (90 ° F) (a temperature well above room temperature).

As used herein, the phrase "parametric modifier" refers to the modification of the local environment and/or the local chemistry of the superconducting material in such a manner as to affect one or more parameters which control or impact upon the level of the critical temperature of the superconducting phase. The parametric modifier thus acts to modify the local chemistry or local environment of the unit cells and/or other structural and chemical configurations from which the superconducting material is synthesized so as to realize changes in the parameters (particularly parameters relative to the oxidation states of the copper atoms or the local electronic environment) affecting the critical temperature. The parametric modifier may also act to affect the interaction between the otherwise shielded orbitals of adjacent atoms of the unit cell, in particular the d orbitals, and in some cases, the f orbitals as well. The parametric modifier can additionally act to produce changes in certain parameters which are positive in their effects on the critical temperature while at the same time avoiding otherwise related adverse changes in other parameters which would negatively affect the critical temperature. Thus, normally dependent parameters are uncoupled from one another.

We have demonstrated that the incorporation of fluorine into the matrix of $Y_1 Ba_2 Cu_3 O_{7-x}$ material has been shown to raise the zero resistance temperature thereof from about 95K to 155-168K. As will be demonstrated hereinafter, when fluorine is substituted for at least some of the labile oxygen atoms in the Cu-X-Cu chains, improved thermal stability results. More particularly, it is possible to hypothesize that due to the fact that fluorine is the most electronegative of elements, fluorine increases the spin pairing energy. The subject inventors thus submit that fluorine atoms substitute for bridging oxygen atoms in the Cu-O-Cu chains, thereby increasing orbital overlap between adjacent copper atoms in the chains and creating a more strongly bonded spin pair. It is this stronger bond which is able to resist decoupling forces generated by increased temperature. The result is that the spin breaking temperature of at least the Bose particles in the chains is increased and not only is the superconducting $T_c$ of the system increased, but the stability (defined herein as the ability of the system to maintain the original $T_c$ over a given period of time and a given range of temperatures) is also increased.

Additionally, the instant inventors have found that atoms of the parametric modifier, when subjected to conditions described hereinafter, will also react with Ba atoms yielding a $BaF_2$ phase. The inventors found that $BaF_2$ formed a few monolayers (i.e., layers of 1 - 2 nm (10-20 angstroms) thickness) on the surface of the parametrically modified YBaCuO material. These $BaF_2$ monolayers serve as a surface passivation layer which protects the underlying material from attack by moisture and other environmental factors.

Therefore, the instant inventors submit that a parametric modifier element, such as fluorine, is capable of thermally and environmentally stabilizing previously unstable superconducting systems. The stabilization of high $T_c$ systems through the introduction of a parametric modifier element will be demonstrated in the Examples set forth in the Detailed Description which follows hereinafter.

In a first embodiment, the invention described herein provides for the replacement of at least some unstable atoms of the valency determining element in the copper-oxygen superconducting pathway of a ceramic oxide type superconducting material with a more stable, valancy determining element. The experimental procedure disclosed herein is most clearly applicable to the high $T_c$ superconducting material having the stoichiometric composition $YBa_2 Cu_3 O_7$. In particular, the method of the subject invention begins through the conventional preparation of 90K, $YBa_2 Cu_3 O_7$ superconducting material. This material is then annealed at an elevated temperature (approximately 400-600 degrees Centigrade) for a preselected length of time for the purpose of removing controlled amounts of oxygen therefrom. Following this heat treatment procedure, the critical temperature of the material decreases in proportion to the amount of oxygen removed. The material is then subjected to a fluorinated glow discharge plasma which effectively restores the critical temperature thereof to, and maintains the critical temperature thereof, at least at its initial value. The efficacy of this thermal stabilization technique is proved, because, when the fluorinated material is subjected to another thermal anneal at the same temperature and for the same length of time as the initial anneal, no fluorine or oxygen evolves therefrom. In this manner, the addition of highly electronegative fluorine atoms to replace at least some of the most weakly bound oxygen atoms in the Cu-O superconducting pathway of the $YBa_2 Cu_3 O_7$ system is clearly shown to increase the thermal stability of that superconducting system.

4

Phys. Rev. Lett., vol. 58, no. 24, 15th June 1987, pages 2579-2581, The American Physical Society, New York; S.R. Ovshinsky et al.: "Super conductivity at 155K" discloses a method of thermally stabilizing a perovskite ceramic defect oxide high $T_c$ superconducting material in which spin pairs of charge carriers move along a superconducting pathway therethrough, the method including the steps of providing the superconducting pathway to include atoms of a multivalent metal element bonded to atoms of a first valency determining element, oxygen forming the first valency determining element and copper forming the multivalent metal element; and substituting atoms of fluorine as a second valency determining element for at least some oxygen atoms disposed between the copper atoms, and, according to the present invention, such a method is characterised in that the substitution is carried out by annealing the superconducting material to a temperature sufficiently high to effuse the least strongly bound oxygen atoms from the superconducting pathway; and subjecting the ceramic defect oxide type superconducting material to a source of labile fluorine atoms for occupying the pathway sites vacated by the effused oxygen atoms.

Thus the superconducing pathways of the material are initially formed with oxygen atoms as the atoms of the first valency determining element and copper atoms as the atoms of the multi-valent metal element. Fluorine atoms are to be substituted for some of the most weakly bound oxygen atoms. The method includes the further step of annealing the superconducting material to a temperature sufficiently high to effuse the most weakly bound oxygen atoms from the superconducting pathway. By then subjecting the ceramic defect oxide type superconducting material to a source of labile fluorine atoms, the fluorine atoms occupy the matrix sites vacated by said oxygen atoms. The lability of the fluorine atoms can be enhanced by decomposing fluorine compounds in a glow discharge plasma which can either be of rf or microwave origin. Preferably, a volatile form of a fluorine compound is introduced into the plasma, and the preferable form of the nitrogen compound precursor is $NF_3$. The rate of incorporation of fluorine atoms into the superconducting pathway can be controlled by controlling the rate of flow of said fluorine compound introduced into said glow discharge plasma or by controlling the length of time that said superconducting pathway is subjected to the fluorine plasma. It is hypothesized that the fact that the fluorine atoms are more electronegative than the oxygen atoms, provides for the creation of a stronger copper-fluorine-copper bond (vis-a-vis, the copper-oxygen-copper bond) and spin pairs of charge carriers are more tightly bound, thereby increasing the thermal stability of the superconducting material.

Additionally, there is disclosed herein a method of environmentally stabilizing a perovskite, ceramic defect oxide, high $T_c$ superconducting material. In particular, conventionally prepared, 90K $YBa_2Cu_3O_7$ superconducting material is subjected to a fluorinated glow discharge plasma. As the process proceeds, fluorine reacts with barium present in the material to form a BaF2 film which deposits upon the exposed surface of the superconducting material. It has been found that this deposited $BaF_2$ layer provides the underlying superconducting material with protection from environmental factors such as moisture induced degradation.

Thus the invention also includes a perovskite, ceramic defect oxide type, high $T_c$ superconducting material, the superconducting material having a thin film of $BaF_2$ formed on the exposed surface thereof for environmentally passivating the bulk of the material.

Furthermore, the invention includes a method of environmentally passivating a superconducting material characterized by steps of:

forming a Ba containing perovskite ceramic defect oxide, high $T_c$ superconducting material; and

fluorinating the exposed surface of the superconducting material during the step of forming the material.

In the accompanying drawings:

Figure 1 is a three dimensional schematic representation of multiple repeating unit cells of the high $T_c$ superconducting system $Y_1Ba_2Cu_3O_{7-x}$; and

Figure 2 is a graphic representation of an ESCA surface analysis of a non-fluorinated sample of a $YBa_2Cu_3O_7$ superconducting material (trace A) and a fluorinated sample of the superconducting material (trace B) which demonstrates the presence of a $BaF_2$ film on the surface of the fluorinated sample.

## EXAMPLES

Samples of the superconducting $YBa_2Cu_3O_7$ material were fluorinated by the plasma processes described hereinbelow to determine the effect of fluorination upon the stability of the material. These processes will now be described in detail.

5

EXAMPLE I

A group of samples was prepared to determine the effects of a microwave plasma exchange of fluorine for relatively unstable constituent oxygen atoms found in the high $T_c$ phases of superconducting perovskite defect oxide material. The subject inventors surmised that since the plasma incorporation could be conducted at temperatures of about 450°C, unwanted inter-metallic solid state reaction could not kinetically occur.

The samples were prepared by blending the following <u>non-fluorinated</u> precursor materials in the following proportions:

| Powder | Mass |
|--------|------|
| $Y_2O_3$ | 1.513 gms |
| $BaCO_3$ | 5.284 gms |
| CuO | 3.198 gms |
| Total | 10.000 gms (80.42 millimoles) |

The precursor materials were then thoroughly mixed and heated, in air, at standard pressure, in a platinum crucible according to the following time-temperature program:

| Time | Temperature |
|------|-------------|
| 8 hours | 950 degrees Centigrade |
| 16 hours | 200 degrees Centigrade |

After the heating and cool-down process, the precursor (non-fluorinated) materials were weighed and the following weight losses were observed. The fluorine-free precursor material lost 1.1204 grams; this large weight loss was primarily due to the evolution of $CO_2$ and secondarily due to the evolution of $O_2$.

Each of the samples were then pressed into a pellet-like configuration measuring approximately 1 centimeter in diameter by approximately 3 millimeters in thickness. The pellets were spacedly positioned into a commercial grade alumina crucible in such a manner that only opposed side wall edges of the pellets contacted the alumina walls of the crucible. The pellets were then fired in an oxygen furnace at standard pressure according to the following time-temperature program:

| Time | Temperature |
|------|-------------|
| 6 hours | Ramped from 200 degrees up to 950 degrees Centigrade |
| 48 hours | Maintained at 950 degrees Centigrade |
| 6 hours | Ramped from 950 degrees Centigrade down to 200 degrees Centigrade in situ |

The pellets fabricated by the foregoing process are orthorhombic and have the nominal composition $Y_1Ba_2Cu_3O_{7.0}$. After completion of the baking and cooling process, the pellets were placed in a dielectric carrier, face down. The pellets are then converted from the orthorhombic to the tetragonal form, which form is characterized by an expanded C-axis. This is accomplished by annealing said pellets at 600° Centigrade for three hours in UHV. Microprobe analysis has revealed that the nominal composition of pellets so treated becomes $Y_1Ba_2Cu_3O_{6.5}$. Thus, unstable oxygen has effused from the unit structure, resulting in significant changes in both the physical structure and electrical properties of the material.

The carrier containing the pellets was then placed into a vacuum chamber operatively connected to have microwave radiation fed from a source into the interior thereof. The carrier was heated to 450° Centigrade at standard atmospheric pressure for a period of 15 minutes and exposed to a 50 SCCM flow of argon. The argon flow was then reduced to approximately 18 sccm and a vacuum of 150 microns was pulled. A microwave plasma at a frequency of 2.45 GHz was initiated, and $NF_3$ (a gaseous precursor source of fluorine) was introduced into the plasma. The microwave plasma was maintained for one hour, at a constant temperature of approximately 450 degrees Centigrade. The following flow rate ranges were maintained:

$NF_3$ 3-5 SCCM
Ar 15-20 SCCM

It is important to note that these flow rate ranges are employed for illustrative purposes only, and that other flow rates may be employed with equal success without departing from the spirit or scope of the invention.

After one hour, the flow of $NF_3$ was terminated. The microwave plasma was extinguished approximately one minute later in order to decompose any residual $NF_3$. The vacuum chamber was then flooded with argon at standard atmospheric pressure while the pellets were slowly cooled down to a temperature of approximately 200° Centigrade prior to removal from said vacuum chamber.

The instant inventors conducted an electron microprobe analysis of the sample of fluorinated material, which analysis indicated that the material had returned to a modified orthorhombic structure having the nominal compositions $Y_1Ba_2Cu_3O_{6.5}F_{.25}$. The inventors further found that certain sites previously occupied by oxygen were now occupied by fluorine. This analysis also revealed that as the concentration of fluorine in the material increased, the concentration of oxygen decreased; and as the concentration of oxygen in the material increased, the concentration of fluorine decreased. The inventors further determined that the peripheral surface area of the pellets exposed to the microwave plasma exhibited a fluorine concentration profile of about 30 atomic percent at the surface; which concentration was reduced to about 3 atomic percent at a 30 micron depth below the surface.

The experimental evidence also indicates that the incorporation of fluorine into the matrix of the superconducting material results in a more stable unit structure, characterized by substantially reduced oxygen diffusion. Specifically, the instant inventors hypothesize that fluorine atoms bond more strongly and more permanently with adjacent copper ($Cu^{II}$) atoms in the Cu-O-Cu chains of the unit cell. Also, fluorine preferentially replaces oxygen at those sites where oxygen is least stable, i.e., in the Cu-O-Cu chain as is evidenced by oxygen effused in the initial annealing process. The result is a stronger, more stable superconducting structure substantially free from thermal degradation caused by oxygen diffusion.

The stability of the fluorinated, high $T_c$ ceramic defect oxide material was demonstrated by reannealing the fluorinated sample in UHV for four hours at 600° Centigrade (the same conditions at which unstable oxygen atoms were effused). The samples were monitored by a quadropole mass spectrometer analysis, which analysis detected no fluorine evolution. These results were confirmed by X-ray diffraction, which diffraction demonstrated no deviation from the modified orthorhombic superconducting structure.

It is based upon the aforementioned electron microprobe and x-ray diffraction analyses that it becomes clear that the aforedescribed exchange method provides for the substitution of fluorine atoms for oxygen atoms already present in the unit cell of the superconducting material, resulting in a more stable unit structure without compromising the high critical temperature of the material (especially when taken in conjunction with the reported and accepted reports that oxygen atoms are preferentially removed from the superconducting chains during the thermal anneal). For the aforementioned reasons, the instant inventors hypothesize that due to the extreme electronegativity of the fluorine atoms, it is possible that spin pairs of charge carriers are more strongly bound between adjacent copper atoms.

EXAMPLE II

In this example, a second sample was prepared employing substantially the method described above with respect to Example I, with the exception that an rf glow discharge plasma is employed to effectuate the exchange, vis-a-vis, the microwave glow discharge plasma. The instant inventors believe that, while operable, the microwave process is an inherently harsh process which effectively etches away several microns of the exposed surface of the pellet samples, thereby possibly resulting in etched uppermost atomic layers.

An rf plasma, being inherently less energetic than a microwave plasma, reduces problems associated with etching of the surface of the samples; thus allowing fluorine to diffuse into the sample to a depth of approximately 50 microns (as compared to a maximum depth of approximately 30 microns in the microwave plasma). Specifically, the non-fluorinated, $YBa_2Cu_3O_7$ pellets, including orthorhombic superconducting pathways, were prepared by the powder metallurgical method described hereinabove with respect to Example 1. The pellets were again exposed to the 600° UHV anneal, which anneal effused unstable oxygen from at least the Cu-O-Cu chains of the superconducting material. The resulting $Y_1Ba_2Cu_3O_{6.5}$ pellet material was tetragonally-shaped and non-superconducting. This tetragonally-shaped material was then subjected to an r.f. glow discharge plasma, in a manner substantially similar to that disclosed in Example I. More specifically, the method employed herein differed only in the r.f. nature of the plasma employed to decompose the fluorinated precursor (such as $NF_3$). After heating the reaction chamber to approximately 200° Centigrade and pulling a vacuum of 150 microns, an rf plasma at a frequency of 13.56 MHz and power of 50 watts was initiated. A flow of 3-5 SCCM $NF_3$ and 15-20 SCCM argon was introduced into the vacuum chamber. The fluorinated plasma generated was maintained for approximately one hour, after which time it was extinguished.

The resulting pellets were then subjected to a microprobe analysis, which analysis disclosed a return of the superconducting orthorhombic structure of the sample, a nominal composition of $Y_1Ba_2Cu_3O_{6.50}F_{.25}$, and the likely incorporation of fluorine into the superconducting chain sites previously occupied by weakly bound oxygen.

The pellets were then subjected to a 600° Centigrade (the temperature of which could be varied from 300-900° Centigrade) UHV anneal for four hours (the time could be varied from 2-72 hours). The thermal anneal was monitored by quadropole mass spectrometer which detected no fluorine or oxygen evolution. From this analysis, it is clear that the sample pellets, so treated to the fluorinated plasma, demonstrated thermal stability, without the loss of high $T_c$. The results obtained by the rf plasma process are thus entirely consistent with those obtained by the microwave process and provide a method by which high $T_c$ phases of ceramic defect oxide superconductors can be stabilized.

While the foregoing results relate to the high $T_c$ YBaCuO system, it should be noted that other high $T_c$, ceramic oxide superconducting systems, such as LaSrNbO, can have the thermal stability thereof increased by substituting a parametric modifier, such as fluorine, for the weakly bound oxygen in the superconducting chains thereof. It is hypothesized that fluorine either provides stronger bonds or provides shorter bond lengths for the valence determining element in the superconducting pathway, thereby increasing spin pair breaking temperatures.

As was mentioned hereinabove, the perovskite, ceramic defect oxide $YBa_2Cu_3O_{7-x}$ superconducting material may also be environmentally stabilized, (i.e., protected from environmental factors such as moisture) by the process described in Examples I and II hereinabove. Specifically, conventionally prepared YBaCuO superconducting material forms 1 to 5 monolayers, (i.e., layers of 0.2 - 2 nm (2 to 20 angstroms) thickness), of a $BaF_2$ film atop the exposed surface of the superconducting material when exposed to a fluorinated glow discharge plasma. The $BaF_2$ film is typically between 2 - 5 nm (20 to 50 angstroms) thick. Thus, in addition to heightening thermal stability, the fluorinated glow discharge plasma process is also responsible for forming an environmentally passivating $BaF_2$ film upon the superconducting material.

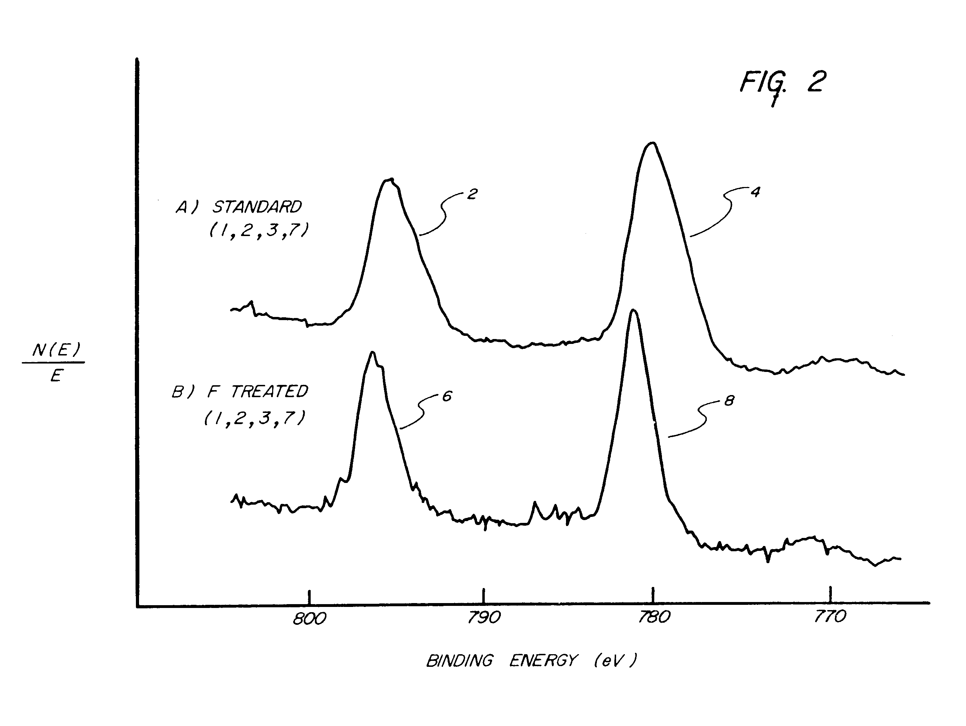

Experimental evidence has been reproduced herein to confirm the above reported results. Specifically, Figure 2 is a graphic representation of an ESCA analysis of non-fluorinated (trace A) and fluorinated (trace B) YBaCuO superconducting material. It is important to note that ESCA analysis is an analytical method for determining the composition of the surface of a sample. As used herein, surface includes up to a depth of 5 nm (50 angstroms) into the bulk of the material being analyzed.

Figure 2, trace A, illustrates a non-fluorinated sample of the YBaCuO superconducting material wherein peaks 2 and 4 are indicative of $Ba(OH)_2$ and $BaCO_3$ present on the surface of said superconducting material. Trace B of Figure 2, illustrates a fluorinated sample of the superconducting material wherein peaks 6 and 8 demonstrate significant narrowing as compared to peaks 2 and 4 of trace A. Analysis of these results shows that the $Ba(OH)_2$ and $BaCO_3$ detected in the non-fluorinated sample are not present in the fluorine treated sample. Additionally, peak 8 indicates the presence of $BaF_2$ film on the surface of the fluorinated superconducting material. It is this film which environmentally stabilizes the fluorinated superconducting material.

**Claims**

1. A method of thermally stabilizing a perovskite ceramic defect oxide high $T_c$ superconducting material in which spin pairs of charge carriers move along a superconducting pathway therethrough; said method including the steps of providing the superconducting pathway to include atoms of a multivalent metal element bonded to atoms of a first valency determining element, oxygen forming the first valency determining element and copper forming the multivalent metal element; and substituting atoms of fluorine as a second valency determining element for at least some oxygen atoms disposed between the copper atoms, characterized in that said substitution is carried out by annealing said superconducting material to a temperature sufficiently high to effuse the least strongly hound oxygen atoms from the superconducting pathway; and subjecting said ceramic defect oxide type superconducting material to a source of labile fluorine atoms for occupying the pathway sites vacated by said effused oxygen atoms.

2. A method as in Claim 1, including the further step of decomposing a fluorine compound in a glow discharge plasma to provide said source of labile atoms.

3. A method as in Claim 2, including the further step of decomposing said fluorine compound in a microwave plasma.

4. A method as in Claim 2, including the further step of introducing $NF_3$ as the fluorine compound.

5. A method as in Claim 1, wherein the superconducting material has a stoichiometry of $YBa_2Cu_3O_7$ and an initial $T_c$ of about 90K, and the annealing is carried out at 300-800°C for 4-72 hours to effuse oxygen atoms for changing the stoichiometry thereof to $YBa_2Cu_3O_{7-x}$ (where $O < x \leq 1$), whereby the $T_c$ of the material reduces as x increases.

6. A perovskite, ceramic defect oxide type, high $T_c$ superconducting material, said superconducting material having a thin film of $BaF_2$ formed on the exposed surface thereof for environmentally passivating the bulk of the material.

7. A material as in Claim 6, wherein the $BaF_2$ film is 1 - 10 nm (10-100 angstroms) thick.

8. A method of environmentally passivating a superconducting material characterized by steps of:
forming a Ba containing perovskite ceramic defect oxide, high $T_c$ superconducting material; and
fluorinating the exposed surface of the superconducting material during the step of forming said material.

9. A method as in Claim 8, wherein said superconducting material is fluorinated and the method includes the further step of forming a $BaF_2$ passivation layer.

10. A method as in Claim 9, wherein the passivation layer is formed by exposing the non-fluorinated superconducting material to a glow discharge plasma; and
the step of forming a Ba containing superconducting material includes the step of forming said material as YBaCuO.

**Patentansprüche**

1. Verfahren zur thermischen Stabilisierung eines mit Fehlerstellen behafteten Perowskitkeramikoxids hoch-$T_c$-supraleitfähigen Materials, durch das sich auf supraleitfähigen Wegen Spinpaare von Ladungsträgern bewegen mit folgenden Stufen:
Bereitstellung des supraleitfähigen Wegs, um Atome eines mehrwertigen Metalls, die an Atome eines ersten die Wertigkeit bestimmenden Elements gebunden sind, einzubauen, wobei Sauerstoff das die erste Wertigkeit bestimmende Element und Kupfer das mehrwertige Element bildet,
Ersatz von wenigstens einigen zwischen Kupferatomen angeordneten Sauerstoffatomen durch Fluor als zweites die Wertigkeit bestimmendes Element, dadurch gekennzeichnet, daß der Ersatz durchgeführt wird durch Glühen des supraleitfähigen Materials bis zu einer Temperatur, die ausreichend hoch ist, die weniger stark gebundenen Sauerstoffatome aus dem supraleitfähigen Weg ausströmen zu lassen und Aussetzen dieses Fehlstellen enthaltenden keramischen Materials einer Quelle labiler Fluoratome zur Besetzung der Fehlstellen, die durch die abgegebenen Sauerstoffatome frei geworden sind.

2. Verfahren nach Anspruch 1, enthaltend die weitere Stufe der Zersetzung einer Fluorverbindung in einem GlimmentladungsPlasma, um die Quelle labiler Atome bereitzustellen.

3. Verfahren nach Anspruch 2, enthaltend die weitere Stufe der Zersetzung dieser Fluorverbindung in einem Mikrowellen-Plasma.

4. Verfahren nach Anspruch 2, enthaltend die weitere Stufe des Einführens von $NF_3$ als Fluorverbindung.

5. Verfahren nach Anspruch 1, worin das supraleitfähige Material eine Stoichiometrie von $YBa_2Cu_3O_7$ und eine anfängliche $T_c$ von etwa 90K hat und das Glühen 4 bis 72 Stunden lang bei 300 bis 800°C durchgeführt wird, um Sauerstoffatome zur Änderung seiner Stoichiometrie nach $YBa_2Cu_3O_{7-x}$ ($0 < x \leq 1$) ausströmen zu lassen, wobei sich die $T_c$ des Materials verringert wie x sich vergrößert.

**6.** Perowskitkeramik-oxidfehlerhaftes hoch-$T_c$-supraleitfähiges Material, wobei das supraleitfähige Material einen dünnen $BaF_2$-Film aufweist, ausgebildet auf der exponierten Oberfläche davon zum umgebungsmäßigen Passivieren der Masse des Materials.

**7.** Material nach Anspruch 6, worin der $BaF_2$-Film 1 - 10 nm (10-100 angström) dick ist.

**8.** Verfahren zum umgebungsmäßigen Passivieren eines supraleitfähigen Materials, gekennzeichnet durch die Stufen: Bildung eines Ba enthaltenden Perowskitkeramik mit Fehlerstellen hoch-$T_c$-supraleitfähigen Materials und Fluorieren der exponierten Oberfläche des supraleitfähigen Materials während der Stufe der Bildung des Materials.

**9.** Verfahren nach Anspruch 8, worin das supraleitfähige Material fluoriert ist und das Verfahren die weitere Stufe der Bildung der $BaF_2$ Passivierungsschicht enthält.

**10.** Verfahren nach Anspruch 9, worin die Passivierungsschicht gebildet wird durch Aussetzen des nichtfluorierten supraleitfähigen Materials einem Glimmentladungs-Plasma und die Stufe der Herstellung eines Ba enthaltenden supraleitfähigen Materials die Stufe der Herstellung dieses Materials als YBaCuO enthält.

## Revendications

**1.** Une méthode de stabilisation thermique pour un matériau supraconducteur à $T_c$ élevée à oxyde à défauts céramique de pérovskite dans laquelle les paires de spins de porteurs de charge se déplacent le long d'une trajectoire supraconductrice à travers celui-ci, ladite méthode comprenant les étapes consistant à prévoir que la trajectoire de supraconduction comporte des atomes d'un élément métallique multivalent lié à des atomes d'un premier élément déterminant la valence, l'oxygène constituant le premier élément déterminant la valence et le cuivre constituant l'élément métallique multivalent, et à substituer des atomes de fluor, en tant que second élément déterminant la valence, à au moins certains atomes d'oxygène disposés entre les atomes de cuivre, caractérisée en ce que ladite substitution est réalisée par le recuit dudit matériau supraconducteur à une température suffisamment élevée que pour éliminer les atomes d'oxygène les moins fortement liés de la trajectoire de supraconduction, et par la soumission dudit matériau supraconducteur du type oxyde à défauts céramique à une source d'atomes de fluor labiles pour occuper les sites de la trajectoire rendus vacants par lesdits atomes d'oxygène éliminés.

**2.** Une méthode suivant la revendication 1, comportant l'étape supplémentaire consistant à décomposer un composé fluoré dans un plasma à décharge luminescente pour fournir ladite source d'atomes labiles.

**3.** Une méthode suivant la revendication 2, comportant l'étape supplémentaire consistant à décomposer ledit composé fluoré dans un plasma à micro-ondes.

**4.** Une méthode suivant la revendication 2,comportant l'étape supplémentaire consistant à introduire du $NF_3$ comme composé fluoré.

**5.** Une méthode suivant la revendication 1, dans laquelle le matériau supraconducteur a une stoechiométrie de $YBa_2Cu_3O_7$ et une $T_c$ initiale d'environ 90K, et le recuit est réalisé à une température de 300 à 800°C pendant une période de 4 à 72 heures pour éliminer les atomes d'oxygène, afin de modifier sa stoechiométrie en $YBa_2Cu_3O_{7-x}$ (où $0 < x \leq 1$), la $T_c$ du matériau diminuant au fur et à mesure que x augmente.

**6.** Un matériau supraconducteur à $T_c$ élevée du type oxyde à défauts céramique de pérovskite, ledit matériau supraconducteur présentant un mince film de $BaF_2$ formé sur sa surface exposée pour passiver l'ensemble du matériau contre les facteurs ambiants.

**7.** Un matériau suivant la revendication 6, dans lequel le film de $BaF_2$ a une épaisseur de 1 à 10 nm (10 à 100 Ångstroms).

10

**8.** Une méthode de passivation contre les facteurs ambiants pour un matériau supraconducteur, caractérisée par les étapes consistant à:

former un matériau supraconducteur à $T_c$ élevée à oxyde à défauts céramique de pérovskite contenant du Ba, et

fluorer la surface exposée du matériau supraconducteur pendant l'étape de formation dudit matériau.

**9.** Une méthode suivant la revendication 8, dans laquelle ledit matériau supraconducteur est fluoré et la méthode comporte l'étape supplémentaire consistant à former une couche de passivation de $BaF_2$.

**10.** Une méthode suivant la revendication 9, dans laquelle la couche de passivation est formée en exposant le matériau supraconducteur non-fluoré à un plasma à décharge luminescente, et l'étape de formation d'un matériau supraconducteur contenant du Ba comporte l'étape de formation dudit matériau sous forme de YBaCuO.

FIG. I

BARIUM

YTTRIUM

OXYGEN

COPPER

FIG. 2

A) STANDARD
(1,2,3,7)

B) F TREATED
(1,2,3,7)

$\dfrac{N(E)}{E}$

BINDING ENERGY (eV)

EP 0 301 689 B1